(19) Europäisches Patentamt / European Patent Office / Office européen des brevets

(11) **EP 4 642 196 A1**

(12) **EUROPEAN PATENT APPLICATION**
published in accordance with Art. 153(4) EPC

(43) Date of publication:
**29.10.2025 Bulletin 2025/44**

(21) Application number: **23906886.9**

(22) Date of filing: **14.12.2023**

(51) International Patent Classification (IPC):
**H10K 39/10** $^{(2023.01)}$    **H10K 30/40** $^{(2023.01)}$
**H10K 30/88** $^{(2023.01)}$    **H10K 39/18** $^{(2023.01)}$
**H10K 39/12** $^{(2023.01)}$

(52) Cooperative Patent Classification (CPC):
**H10K 30/88; H10K 39/12;** H10K 30/40; H10K 39/18;
Y02E 10/549

(86) International application number:
**PCT/JP2023/044813**

(87) International publication number:
**WO 2024/135521 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.12.2022 JP 2022204306**

(71) Applicant: **Panasonic Holdings Corporation
Osaka, 571-8501 (JP)**

(72) Inventor: **KANEMATSU, Daiji
Kadoma-shi, Osaka 571-0057 (JP)**

(74) Representative: **Grünecker Patent- und
Rechtsanwälte
PartG mbB
Leopoldstraße 4
80802 München (DE)**

(54) **SOLAR CELL MODULE**

(57) A solar cell module 1 according to an example of an embodiment includes a base material 2, a solar battery cell 3 disposed over the base material 2, and a sealing layer 30 that covers the solar battery cell 3. The solar battery cell 3 includes a photoelectric conversion layer 10, a first electrode layer 11 disposed on a first surface side of the photoelectric conversion layer 10, and a second electrode layer 12 disposed on a second surface side of the photoelectric conversion layer 10. A perimeter of the photoelectric conversion layer 10 is positioned inside a perimeter of the base material 2 in plan view. A colored layer 40 is disposed at least in an area not overlapping with the photoelectric conversion layer 10.

FIG. 2

EP 4 642 196 A1

## Description

Technical Field

The present disclosure relates to a solar cell module.

Background Art

Solar cell modules in which a photoelectric conversion layer is formed on an insulating base material such as a glass base material have been conventionally known. PTL 1 discloses a solar cell module as a solar cell module installed in devices such as watches, including a base material, a solar battery cell formed over the base material and in which a photoelectric conversion layer is provided as far as an outer peripheral end of the base material, an extraction electrode layer formed over the base material for extracting electric charges from the solar battery cell, and a sealing layer.

Citation List

Patent Literature

PTL 1: Japanese Patent No. 4776748

Summary of Invention

Technical Problem

The solar cell module installed in devices such as watches is produced by cutting out the base material formed with the photoelectric conversion layer, and thus the photoelectric conversion layer is formed as far as the outer peripheral end of the solar cell module as described in PTL 1. In a perovskite-type solar battery cell, in which a perovskite element is used in the photoelectric conversion layer, the photoelectric conversion layer is likely to discolor due to the presence of water vapor and oxygen. For this reason, when an outer peripheral end face of the photoelectric conversion layer is exposed to the outside, the photoelectric conversion layer may discolor starting from the outer peripheral end face.

Given these circumstances, as a method of inhibiting discoloration starting from the outer peripheral end face of the photoelectric conversion layer, one might consider removing the photoelectric conversion layer formed on an outer periphery of the solar cell module so that the outer peripheral end face of the photoelectric conversion layer is not exposed to the outside. However, the perovskite element is generally black, and thus when the photoelectric conversion layer formed on the outer periphery of the solar cell module is removed as described above, color contrast on a light-receiving surface of the solar cell module would be large, which would impair a sense of unity in appearance. Specifically, the inner side of the solar cell module, in which the photoelectric conversion layer is formed, would be dark, whereas the outer side of the solar cell module, in which the photoelectric conversion layer is not formed, would be bright. For solar cell modules installed in devices such as watches, not only functionality but also design appearance is important, and thus achieving a solar cell module inhibiting the discoloration of the photoelectric conversion layer and also having excellent appearance is an important challenge.

An object of the present disclosure is to provide a solar cell module inhibiting the discoloration of the photoelectric conversion layer and having excellent appearance. Solution to Problem

A solar cell module according to an aspect of the present disclosure includes a base material, a solar battery cell disposed over the base material, and a sealing layer that covers the solar battery cell. The solar battery cell includes a photoelectric conversion layer, a first electrode layer disposed on a first surface side of the photoelectric conversion layer, and a second electrode layer disposed on a second surface side of the photoelectric conversion layer. A perimeter of the photoelectric conversion layer is positioned inside a perimeter of the base material in plan view. A colored layer is disposed at least in an area not overlapping with the photoelectric conversion layer.

Advantageous Effects of Invention

The solar cell module according to the present disclosure can inhibit the discoloration of the photoelectric conversion layer and has excellent appearance over a long term.

Brief Description of Drawings

[Fig. 1] Fig. 1 is a plan view of a solar cell module according to an example of an embodiment.
[Fig. 2] Fig. 2 is a sectional view of the solar cell module according to an example of an embodiment.
[Fig. 3] Fig. 3 is a sectional view of a solar cell module according to another example of an embodiment.
[Fig. 4] Fig. 4 is a sectional view of a solar cell module according to another example of an embodiment.
[Fig. 5] Fig. 5 is a sectional view of a solar cell module according to another example of an embodiment.

Description of Embodiments

An example of an embodiment of a solar cell module according to the present disclosure will be described below in detail with reference to the drawings. Note that aspects obtained by selectively combining the components of a plurality of embodiments and modifications described below are included in the scope of the present disclosure.

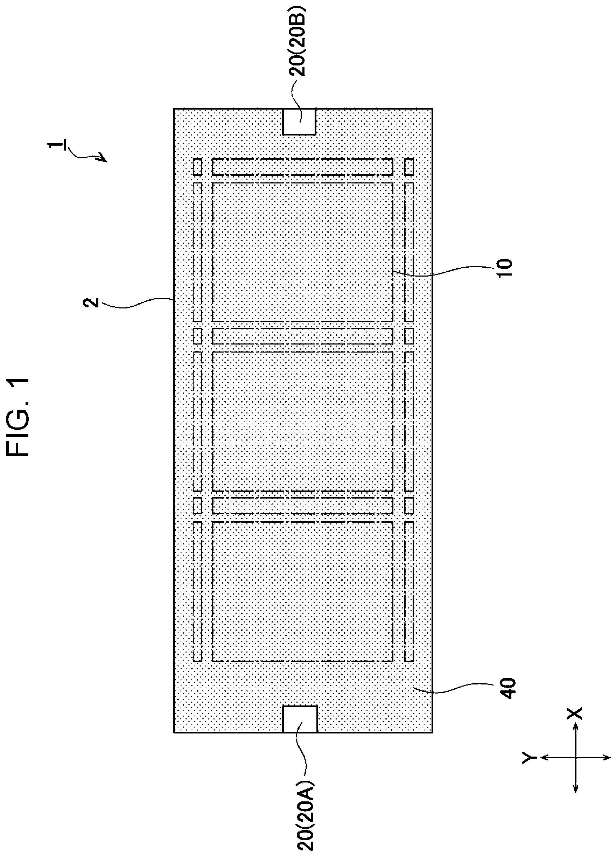

Fig. 1 is a plan view schematically showing a solar cell module 1 according to an example of an embodiment. Fig, 2 is a sectional view of the solar cell module shown in Fig. 1 and is a sectional view of a part in which a solar battery cell 3 is formed. Fig. 1 omits the illustration of a sealing layer 30 and illustrates the contour of a photoelectric conversion layer 10 by the dash-dotted line. Fig. 1 shows an area in which a colored layer 40 is formed with dot hatching.

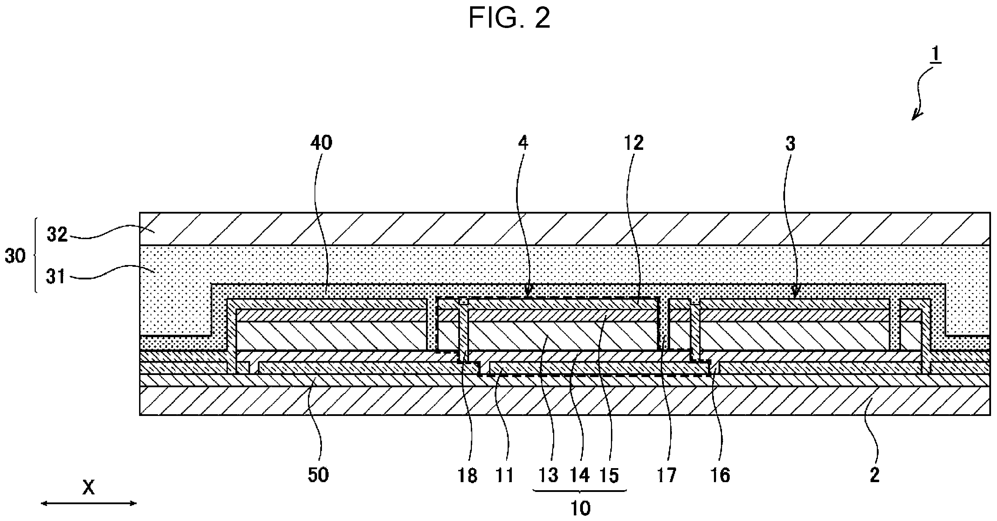

As illustrated in Fig. 1 and Fig. 2, the solar cell module 1 includes a base material 2 and the solar battery cell 3 formed over the base material 2. The solar battery cell 3 includes three unit cells 4 connected in series. Each of the unit cells 4 includes the photoelectric conversion layer 10 containing a perovskite compound, a first electrode layer 11 formed on a first surface side of the photoelectric conversion layer 10, and a second electrode layer 12 formed on a second surface side of the photoelectric conversion layer 10. Note that in the present embodiment, the surface of the base material 2 is a light-receiving surface of the solar cell module 1.

As illustrated in Fig. 1 and Fig. 2, in plan view of the solar cell module 1, the base material 2 has a rectangular shape, and perimeters of the first electrode layer 11 and the second electrode layer 12 overlap with a perimeter of the base material 2. In other words, the first electrode layer 11 and the second electrode layer 12 are formed across the entire surface of the base material 2 except parts in which grooves 16 and 17, which will be described below, are formed. In addition, in plan view of the solar cell module 1, a perimeter of the photoelectric conversion layer 10 is positioned inside the perimeter of the base material 2. With this, an outer peripheral end face of the photoelectric conversion layer 10 is not exposed to the external air, and thus discoloration starting from the outer peripheral end face of the photoelectric conversion layer 10 can be inhibited.

In plan view of the solar cell module 1, the shortest length from the perimeter of the photoelectric conversion layer 10 to the perimeter of the base material 2 is preferably greater than or equal to 0.5 mm and more preferably greater than or equal to 2.0 mm. In this case, discoloration starting from the outer peripheral end face of the photoelectric conversion layer 10 can be markedly inhibited. The shortest length from the perimeter of the photoelectric conversion layer 10 to the perimeter of the base material 2 may be substantially constant or different in the plane. In the present embodiment, as shown in Fig. 1, the shortest length from the perimeter of the photoelectric conversion layer 10 extending in the X direction to the perimeter of the base material 2 is smaller than the shortest length from the perimeter of the photoelectric conversion layer 10 extending in the Y direction to the perimeter of the base material 2.

As will be described below in detail, the solar cell module 1 further includes an extraction electrode layer 20, the sealing layer 30, and the colored layer 40. The extraction electrode layer 20 is an electrode for extracting electric energy from the solar battery cell 3 to the outside of the solar cell module 1. The extraction electrode layer 20 includes an extraction electrode layer 20A electrically connected to the first electrode layer 11 and an extraction electrode layer 20B electrically connected to the second electrode layer 12. The extraction electrode layer 20A is formed at a first end of the base material 2 in the X direction, and the extraction electrode layer 20B is formed at a second end in the X direction on the side opposite to the first end. The extraction electrode layer 20 is formed in areas not overlapping with the photoelectric conversion layer 10 in plan view of the solar cell module 1.

The sealing layer 30 is a layer interposing the solar battery cell 3 between the sealing layer 30 and the base material 2 to inhibit water vapor and oxygen from flowing into the module. The sealing layer 30 is formed so as to cover the solar battery cell 3 (the photoelectric conversion layer 10, the first electrode layer 11, and the second electrode layer 12) and has openings in areas corresponding to the extraction electrode layer 20.

The colored layer 40 has an absorption rate at least at some wavelengths of visible light within wavelengths of 380 nm to 780 nm of at least greater than or equal to 30% and preferably greater than or equal to 50%. The colored layer 40 preferably has a black color or a dark blue color, which is similar to the color of the photoelectric conversion layer 10, or a color close thereto. The colored layer 40 is formed between the second electrode layer 12 and the sealing layer 30. The colored layer 40 is formed at least in an area not overlapping with the photoelectric conversion layer 10 in plan view of the solar cell module 1. This reduces color contrast on a light-receiving surface of the solar cell module 1 and can achieve the solar cell module 1 with an improved sense of unity in appearance.

In the present embodiment, as shown in Fig. 1, the colored layer 40 is formed so as to cover the entire second electrode layer 12 except parts in which the extraction electrode layer 20 is formed. In other words, the colored layer 40 is formed also in an area in which the photoelectric conversion layer 10 is formed in addition to an outer periphery of the solar cell module 1, in which the photoelectric conversion layer 10 is not formed. By forming the colored layer 40 so as to cover the entire second electrode layer 12, color contrast on the light-receiving surface of the solar cell module 1 can be further reduced.

The solar cell module 1 may include an inorganic film 50 formed on the base material 2. The inorganic film 50 is interposed between the base material 2 and the first electrode layer 11. For the inorganic film 50, for example, an inorganic film of the same type as a barrier layer of a second layer 32, which will be described below, can be used.

For the base material 2, a conductive base material with an insulating layer formed on the surface may be used, but an insulating base material is preferably used. The base material 2 contains, for example, a material having transparency to sunlight with wavelengths of longer than or equal to 400 nm and shorter than or equal to 1,000 nm and having a low water vapor transmission rate. The base material 2 may be a base material made of resin or a base material made of glass. The thickness of the base material 2 is, for example, greater than or equal to 0.02 mm and less than or equal to 3 mm.

A configuration of the solar battery cell 3 according to an example of an embodiment will be described below in detail. Fig. 2 shows an example of a preferred layer structure of the solar battery cell 3, but the structure of the solar battery cell 3 is not limited to this example.

As shown in Fig. 1 and Fig. 2, the solar battery cell 3 includes three unit cells 4 that are arranged in the X direction and are connected in series. Note that the number of the unit cells 4 included in the solar battery cell 3 is not particularly limited and may be four or more.

The solar battery cell 3 includes a pair of electrodes (the first electrode layer 11 and the second electrode layer 12) and the photoelectric conversion layer 10 formed between the pair of electrodes and containing a perovskite compound. In other words, the solar battery cell 3 is a perovskite-type solar battery cell.

The photoelectric conversion layer 10 includes a light absorption layer 13, an electron transport layer 14, and a hole transport layer 15 and has a laminated structure formed in such a manner that the electron transport layer 14 and the hole transport layer 15 interpose the light absorption layer 13 from both sides. In the photoelectric conversion layer 10 of the present embodiment, the electron transport layer 14, the light absorption layer 13, and the hole transport layer 15 are formed in this order from the side closer to the base material 2 except parts in which grooves, which will be described below, are formed. The light absorption layer 13 contains a perovskite compound represented by a composition formula $ABX_3$ (where A is a monovalent cation, B is a divalent cation, and X is a halogen anion).

An example of A of the perovskite compound ($ABX_3$) is a monovalent cation represented by $R_1R_2R_3$-N-H. When $R_1$ and $R_2$ are each H and $R_3$ is $CH_3$, A is methyl ammonium ($CH_3NH_3$). The functional groups $R_1$, $R_2$, and $R_3$ contain, for example, at least one element selected from carbon, hydrogen, nitrogen, and oxygen. When the functional groups $R_1$, $R_2$, and $R_3$ contain a carbon atom, the total of the number of carbon atoms of the functional groups $R_1$, $R_2$, and $R_3$ is preferably less than or equal to four. The functional groups $R_1$, $R_2$, and $R_3$ may contain a Group 1 element such as Rb or Cs.

B of $ABX_3$ is a divalent cation as described above. B is, for example, a divalent cation of a transition metal, a Group 13 element, a Group 14 element, or a Group 15 element. Specific examples of B include $Pb^{2+}$, $Ge^{2+}$, and $Sn^{2+}$. B may contain at least one selected from $Pb^{2+}$ and $Sn^{2+}$, and another element may substitute for part of $Pb^{2+}$ and $Sn^{2+}$. Examples of the substituting element include Bi, Sb, In, Ge, and Ni. X of $ABX_3$ is at least one selected from Cl, Br, and I.

Each site of A, M, and X may be occupied by a plurality of types of ions. Specific examples of the perovskite compound ($ABX_3$) include $CH_3NH_3PbI_3$, $CH_3CH_2NH_3PbI_3$, $NH_2CHNH_2PbI_3$, $CH_3NH_3PbBr_3$, $CH_3NH_3PbCl_3$, $CsPbI_3$, and $CsPbBr_3$. The light absorption layer 13 containing $CH_3NH_3PbI_3$ is also called a PVSK element.

The electron transport layer 14 contains an n-type semiconductor and is also called an n layer. Examples of an electron transport material constituting the electron transport layer 14 include anatase-type titanium oxide and tin oxide. The hole transport layer 15 contains a p-type semiconductor and is also called a p layer. The hole transport layer 15 contains a hole transport material having oxidation-reduction sites. Examples of the hole transport material constituting the hole transport layer 15 include 2,2',7,7'-tetrakis(N,N'-di-p-methoxyphenylamino)-9,9'-spirobifluorene (Spiro-OMeTAD).

The first electrode layer 11 preferably has light transmissivity not to block entry of light to the photoelectric conversion layer 10. The light transmission rate of the first electrode layer 11 is, for example, greater than or equal to 85% in a wavelength range of longer than or equal to 450 nm and shorter than or equal to 900 nm. The second electrode layer 12 may have light transmissivity as in the first electrode layer 11 or does not necessarily have light transmissivity.

The sheet resistance of the first electrode layer 11 and the second electrode layer 12 is preferably less than or equal to 200 $\Omega/\square$ or may be less than or equal to 50 $\Omega/\square$. A preferred example of each electrode layer is a transparent conductive layer containing a transparent conductive oxide, which is a metal oxide such as indium oxide or zinc oxide doped with tungsten, tin, antimony, or the like, such as indium tin oxide (ITO). The thickness of the transparent conductive layer is, for example, greater than or equal to 30 nm and less than or equal to 300 nm. Each electrode layer can be formed as a film by a conventionally known method such as sputtering.

The solar battery cell 3 is formed with grooves 16, 17, and 18. The grooves 16, 17, and 18 are formed by removing part of the layers constituting the solar battery cell 3 and extend in the X direction or the Y direction. Each groove can be formed by scribing or the like, which is conventionally known. The width of each groove is, for example, greater than or equal to 30 $\mu$m and less than or equal to 300 $\mu$m.

The groove 16 is a groove dividing the first electrode layer 11 of each unit cell 4. The groove 17 is a groove dividing the light absorption layer 13, the hole transport layer 15, and the second electrode layer 12 of each unit cell 4. Note that the groove 17 is only required to divide the second electrode layer 12 of each unit cell 4, and the light absorption layer 13 and the hole transport layer 15 are not necessarily divided by the groove 17. The groove 17 is filled with the colored layer 40 so that gaps are not formed in the groove. In the present embodiment, it is assumed that each unit cell 4 is defined by the grooves 16 and 17.

The groove 18 is formed passing through the hole transport layer 15, the light absorption layer 13, and the electron transport layer 14 to expose the first electrode layer 11 of the unit cell 4. The second electrode layer 12 of the unit cell 4 is formed in the groove 18. This electrically connects the second electrode layer 12 to the first electrode layer 11 of the adjacent unit cell 4. That is, the groove 18 functions as a conductive path connecting the unit cells 4 in series.

The solar battery cell 3 is produced by, for example, the following method:

(1) The first electrode layer 11 and the electron transport layer 14 are formed over the base material 2 in this order.
(2) Part of the first electrode layer 11 is laser-scribed to form the groove 16.
(3) The light absorption layer 13 and the hole transport layer 15 are formed on the electron transport layer 14 in this order.
(4) Part of the hole transport layer 15, the light absorption layer 13, and the electron transport layer 14 is laser-trimmed to remove the photoelectric conversion layer 10 on the outer periphery to form the groove 18.
(5) The second electrode layer 12 is formed on the hole transport layer 15. In this process, the second electrode layer 12 is formed in the groove 18, and the conductive path is formed.
(6) Part of the second electrode layer 12, the hole transport layer 15, and the light absorption layer 13 is laser-patterned to form the groove 17.

The light absorption layer 13, the electron transport layer 14, and the hole transport layer 15 can be formed as films by, for example, applying a solution dissolving a component material of each layer to the surface of the base material 2. These layers may be formed as films by meniscus application, spin coating, or using a dispenser. The thickness of each layer is not particularly limited and is, for example, greater than or equal to 10 nm and less than or equal to 500 nm.

Configurations of the sealing layer 30 and the colored layer 40 according to an example of an embodiment will be described below in detail.

The sealing layer 30 is a layer covering the entire solar battery cell 3 and has a function of inhibiting water vapor and oxygen from flowing into the module. The sealing layer 30 may have a function of capturing water vapor and the like. The sealing layer 30 can be made a single-layer structure or a multilayer structure having three or more layers, and in the present embodiment, the sealing layer 30 has a two-layer structure including a first layer 31 and the second layer 32.

The first layer 31 is formed so as to cover the entire colored layer 40. The first layer 31 is preferably in intimate contact with the colored layer 40 without any gaps so that no gaps are formed between the first layer 31 and the colored layer 40. In this case, an inflow of water vapor and oxygen into the module decreases, and the discoloration of the photoelectric conversion layer 10 is inhibited. The first layer 31 preferably contains a resin having low transmission rates of water vapor and oxygen. The first layer 31 may contain a moisture absorbing filler. The first layer 31 having a function of capturing water is also called a getter layer.

Thr resin constituting the first layer 31 is only required to be a resin having low transmission rates of water vapor and oxygen and having good adhesion to the colored layer 40; preferred examples of the resin include olefin-based polymers. The olefin-based polymer is a polymer with a unit derived from an olefin as a main structural unit. The first layer 31 is, for example, a layer in which the moisture absorbing filler is dispersed in the olefin-based polymer. Note that the first layer 31 may contain components other than the olefin-based polymer and the moisture absorbing filler. Examples of the other components include stickiness imparting agents, curing accelerator, antioxidants, plasticizers, and rubber components.

The olefin-based polymer is preferably a copolymer of two or more olefins or a copolymer of an olefin and a monomer other than an olefin, such as a non-conjugated diene or styrene. Examples of the copolymer include ethylene-non-conjugated diene copolymers, ethylene-propylene copolymers, ethylene-propylene-non-conjugated diene copolymers, ethylene-butene copolymers, propylene-butene copolymers, propylene-butene-non-conjugated diene copolymers, styrene-isobutene copolymers, styrene-isobutene-styrene copolymers, and isobutene-isoprene copolymers.

The olefin-based polymer preferably has a cross-linked structure and is obtained by the reaction of a copolymer containing a first reactive functional group and a copolymer containing a second reactive functional group. The reactive functional group can be selected from the group consisting of an epoxy group, a carboxy group, an acid anhydride group, an amino group, a hydroxy group, and an isocyanate group, and they are used in a combination reacting with each other. Specific examples of the combination of the reactive functional groups include an epoxy group and a carboxy group, an epoxy group and an acid anhydride group, and a carboxy group and an acid anhydride group.

Examples of the moisture absorbing filler include non-heat-treated hydrotalcite, semi-heat-treated hydrotalcite, heat-treated hydrotalcite, calcium oxide, magnesium oxide, heat-treated dolomite, calcium hydride, strontium oxide, aluminum oxide, barium oxide, molecular sieves, and silica.

The thickness of the first layer 31 is, for example, greater than or equal to 10 $\mu$m and less than or equal to 100 $\mu$m and preferably greater than or equal to 30 $\mu$m and less than or equal to 70 $\mu$m. When the thickness of the first layer 31 is within the range, good sealing performance and the performance of capturing water vapor and the like can be ensured. The material constituting the first layer 31 is supplied in film form in a production process of the solar cell module 1 and flows by being heated, pressurized, or pressurized while being heated to be in intimate contact with the colored layer 40 without any gaps.

The second layer 32 is a layer having low transmission rates of water vapor and oxygen, is provided so as to cover the entire first layer 31, and inhibits an inflow of water vapor and oxygen into the module. The second layer 32 preferably includes a resin film having a barrier layer. The resin film mainly contains, for example, a resin such as a polyolefin-based polymer such as polyethylene, polypropylene, and polyvinyl chloride, a polyester such as polyethylene terephthalate, polycarbonate, or polyimide. The barrier layer is preferably formed on an inner surface of the resin film, that is, the surface facing the first layer 31. Examples of the barrier layer include inorganic films such as silica vapor-deposited films, silicon nitride films, and silicon oxide films.

The thickness of the second layer 32 is, for example, greater than or equal to 20 $\mu$m and less than or equal to 150 $\mu$m and preferably greater than or equal to 50 $\mu$m and less than or equal to 100 $\mu$m. Note that the thickness of the barrier layer is smaller than that of the resin film, and thus the thickness of the second layer 32 is substantially the same as the thickness of the resin film constituting the second layer 32. The relation between the thicknesses of the first layer 31 and the second layer 32 is not particularly limited.

The colored layer 40 is formed at least in an area not overlapping with the photoelectric conversion layer 10 in plan view of the solar cell module 1. In the present embodiment, the colored layer 40 is directly formed on the back surface of the second electrode layer 12. The colored layer 40 is formed on the entire area except the parts in which the extraction electrode layer 20 is formed on the back surface of the second electrode layer 12. The colored layer 40 is preferably in intimate contact with the second electrode layer 12 without any gaps so that there are no gaps between the colored layer 40 and the second electrode layer 12. In this case, color contrast on the light-receiving surface of the solar cell module 1 is further reduced, and a solar cell module with an improved sense of unity in appearance can be achieved.

The colored layer 40 has an absorption rate at least at some wavelengths of visible light within wavelengths of 380 nm to 780 nm of at least greater than or equal to 30% and preferably greater than or equal to 50%. The colored layer 40 is only required to have an absorption rate of greater than or equal to 50% for part of visible light and preferably has an absorption rate of greater than or equal to 50% for the entire visible light, that is, in all the wavelengths within wavelengths of 380 nm to 780 nm. In this case, the color of the colored layer 40 is likely to be a black color or a dark blue color, which is similar to the color of the photoelectric conversion layer 10, or a color close thereto. The absorption rate of the colored layer 40 at least at some wavelengths of visible light within wavelengths of 380 nm to 780 nm is preferably greater than or equal to 60%, more preferably greater than or equal to 70%, particularly preferably greater than or equal to 80%, and most preferably greater than or equal to 90%.

The absorption rate of the colored layer 40 is preferably larger than the absorption rate of the photoelectric conversion layer 10 at least at some wavelengths of visible light within wavelengths of 380 nm to 780 nm. In this case, color contrast on the light-receiving surface of the solar cell module 1 is further reduced, and thus the solar cell module 1 with a further improved sense of unity in appearance can be achieved.

An absorption rate A (%) of the colored layer 40 can be calculated by the following expression after measuring a light transmission rate (T) and a light refection rate (R) of the colored layer 40 using a spectrophotometer that enables measurement of a target wavelength range:

$$A = 100 - T - R$$

Measurement of the light transmission rate and the light reflection rate can be performed based on JIS-K7375. As the spectrophotometer, SolidSpec-3700 manufactured by Shimadzu Corporation can be used.

The material constituting the colored layer 40 is only required to be a material having an absorption rate at least at some wavelengths of visible light within wavelengths of 380 nm to 780 nm of at least greater than or equal to 30% and preferably greater than or equal to 50% and having good adhesion to the second electrode layer 12 and preferably has insulation. When the colored layer 40 has insulation, the groove 17 formed in the solar battery cell 3 can be filled with the colored layer 40. This further reduces color contrast on the light-receiving surface of the solar cell module 1 and can achieve a solar cell module with an improved sense of unity in appearance.

Examples of the material constituting the colored layer 40 include amorphous silicon and niobium oxide ($Nb_2O_x$ ($x \leq 5$)). The colored layer 40 can be formed by, for example, chemical vapor deposition (hereinafter referred to as "CVD") or sputtering. The colored layer 40 may have a single-layer structure or a multilayer structure.

Note that the colored layer 40 is not limited to the inorganic film described above. The colored layer 40 may be, for example, a resin film in which a black coloring material is dispersed in a resin. The resin for use in the colored layer 40 is not particularly limited, and examples thereof include polyolefins, polyesters, and epoxy resins. Examples of the black coloring material for use in the colored layer 40 include black pigments such as carbon black, aniline black, titanium black, nonmagnetic ferrite, and magnetite. The content of the coloring material is, for example, about 5% by volume to 50% by volume with respect to the volume of the colored layer 40.

The thickness of the colored layer 40 is preferably smaller than the thickness of the photoelectric conversion layer 10. In this case, the area in which an outer peripheral end face of the colored layer 40 is exposed to the outside air is reduced, and thus water vapor and oxygen can be inhibited from flowing into the module via the outer peripheral end face of the colored layer 40.

The thickness of the colored layer 40 is preferably greater than or equal to 50 nm and more preferably greater than or equal to 100 nm. In this case, color contrast on the light-receiving surface of the solar cell module 1 is reduced, and a solar cell module with an improved sense of unity in appearance can be achieved. In addition, the thickness of the colored layer 40 is preferably less than or equal to 750 nm and more preferably less than or equal to 500 nm. In this case, an inflow of water vapor and oxygen into the module via the outer peripheral end face of the colored layer 40 decreases, and the discoloration of the photoelectric conversion layer 10 is further inhibited. Thus, an example of a preferred range of the thickness of the colored layer 40 is greater than or equal to 50 nm and less than or equal to 750 nm.

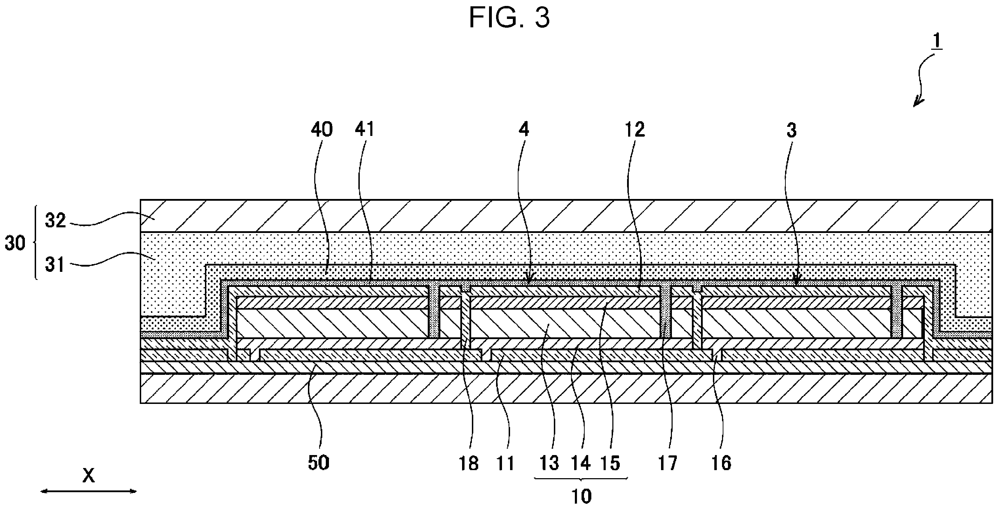

Fig. 3 is a sectional view of a solar cell module 1X according to another example of an embodiment. As shown in Fig. 3, the solar cell module 1X differs from the solar cell module 1 in that an intermediate layer 41 is formed between the colored layer 40 and the second electrode layer 12.

The refractive index of the intermediate layer 41 is smaller than the refractive index of the colored layer 40 and is larger than the refractive index of the second electrode layer 12. By forming the intermediate layer 41 between the colored layer 40 and the second electrode layer 12, color contrast on the light-receiving surface of the solar cell module 1 is further reduced, and a solar cell module with a further improved sense of unity in appearance can be achieved. The difference in the refractive index between the intermediate layer 41 and the colored layer 40 is preferably greater than or equal to 0.1 and more preferably greater than or equal to 0.2. The refractive index of the intermediate layer 41 is, for example, greater than or equal to 2.0 and less than or equal to 3.0.

The intermediate layer 41 is preferably formed so as to cover the entire back surface of the second electrode layer 12, but this is not limiting. The intermediate layer 41 may be formed, for example, only in an area not overlapping with the photoelectric conversion layer 10 in plan view of the solar cell module 1X, that is, an area with the photoelectric conversion layer 10 removed.

The intermediate layer 41 preferably has insulation as in the colored layer 40. With this, the groove 17 formed in the solar battery cell 3 can be filled with the intermediate layer 41, and a solar cell module with an improved sense of unity in appearance can be achieved.

Examples of the material constituting the intermediate layer 41 include silicon nitride, silicon oxide, zirconium oxide, aluminum oxide, and aluminum nitride.

The intermediate layer 41 can be formed by, for example, CVD or sputtering. The intermediate layer 41 may have a single-layer structure or a multilayer structure. The intermediate layer 41 may have a structure in which, for example, silicon nitride and silicon oxide are laminated on each other. The thickness of the intermediate layer 41 is, for example, greater than or equal to 30 nm and less than or equal to 300 nm, which varies depending on its type.

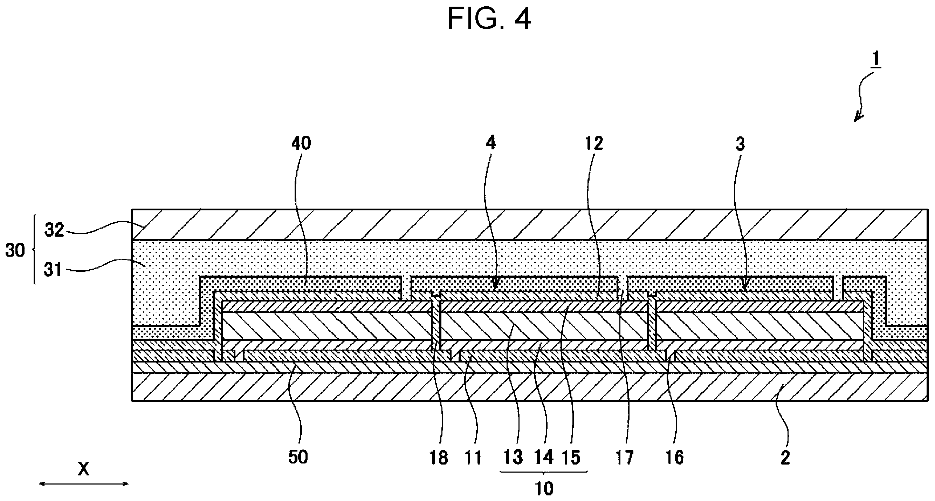

Fig. 4 is a sectional view of a solar cell module 1Y according to another example of an embodiment. As shown in Fig. 4, the solar cell module 1Y differs from the solar cell module 1 in that the groove 17 does not divide the photoelectric conversion layer 10 but divides the second electrode layer 12 and the colored layer 40. The groove 17 does not divide the photoelectric conversion layer 10, and thus color contrast on the light-receiving surface of the solar cell module 1Y is further reduced without filling the groove 17 with the colored layer 40, and a solar cell module with an improved sense of unity in appearance can be achieved. In addition, the groove 17 divides the colored layer 40, and thus a material having conductivity can be used for the colored layer 40.

Examples of the material constituting the colored layer 40 include amorphous silicon, niobium oxide ($Nb_2O_x (x \leq 5)$), and conductive carbon. The colored layer 40 can be formed by, for example, CVD or sputtering.

The solar battery cell 3 formed with the colored layer 40 shown in Fig. 4 is produced by, for example, the following method:

(1) The first electrode layer 11 and the electron transport layer 14 are formed over the base material 2 in this order.
(2) Part of the first electrode layer 11 is laser-scribed to form the groove 16.
(3) The light absorption layer 13 and the hole transport layer 15 are formed on the electron transport layer 14 in this order.
(4) Part of the hole transport layer 15, the light absorption layer 13, and the electron transport layer 14 is laser-trimmed to remove the photoelectric conversion layer 10 on the outer periphery to form the groove 18.
(5) The second electrode layer 12 is formed on the hole transport layer 15.
(6) The colored layer 40 is formed at least in an area not overlapping with the photoelectric conversion layer on the second electrode layer 12.
(7) Part of the colored layer 40 and the second electrode layer 12 is laser-patterned to form the groove 17.
(8) The sealing layer 30 is formed on the colored layer 40 so as to cover the entire second electrode layer 12.

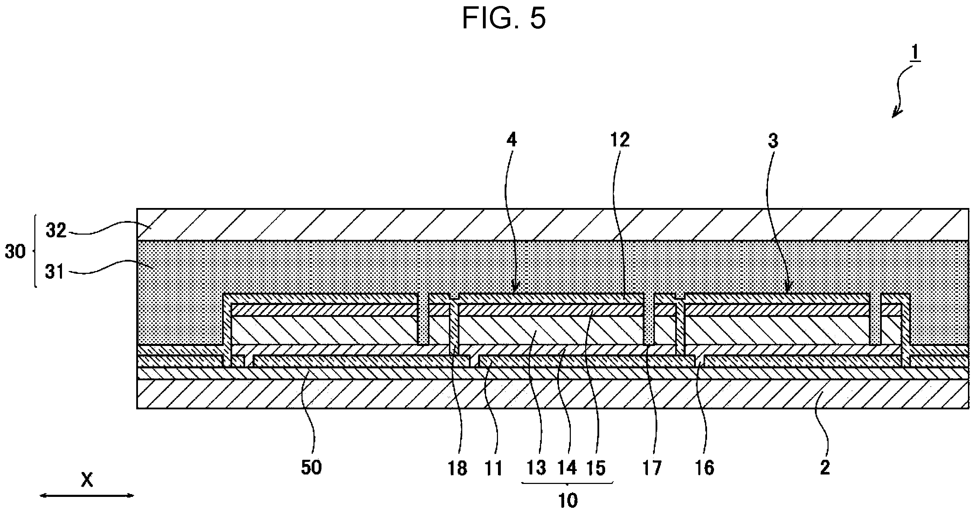

Fig. 5 is a sectional view of a solar cell module 1Z according to another example of an embodiment. As shown in Fig. 5, the solar cell module 1Z differs from the solar cell module 1 in that the colored layer 40 is not formed.

The solar cell module 1Z includes the sealing layer 30 including the first layer 31 and the second layer 32 as in the solar cell module 1. The first layer 31 of the solar cell module 1Z contains a coloring material. With this, the sealing layer 30 has an absorption rate at least at some wavelengths of visible light within wavelengths of 380 nm to 780 nm of at least greater than or equal to 30% and preferably greater than or equal to 50%. In other words, the first layer 31 of the solar cell module 1Z has a function of capturing water as the sealing layer and a function of reducing color contrast on the light-receiving surface as the colored layer. The solar cell module 1Z in which the coloring material is added to the first layer 31 does not form the colored layer 40 and can thus simplify its production process compared to that for the solar cell module 1.

As described above, examples of the coloring material include black pigments such as carbon black, aniline black, titanium black, nonmagnetic ferrite, and magnetite. The content of the coloring material is preferably greater than or equal to 5% by volume and more preferably greater than or equal to 10% by volume with respect to the volume of the first layer 31. In this case, color contrast on the light-receiving surface of the solar cell module 1Z is further reduced, and a solar cell module with an improved sense of unity in appearance can be achieved. In addition, the content of the coloring material is preferably less than or equal to 50% by volume and preferably less than or equal to 40% by volume. In this case, the first layer 31 markedly exhibits the function of capturing water as the sealing layer. Thus, an example of a preferred range of the content of the coloring material is greater than or equal to 5% by volume and less than or equal to 50% by volume with respect to the volume of the first layer 31.

The content of the coloring material in the first layer 31 may be substantially uniform across the thickness direction of the first layer 31 or vary in the thickness direction of the first layer 31. For example, by making the first layer 31 a two-layer structure including a layer having a higher content of the coloring material and a layer having a lower content of the coloring material, the content of the coloring material closer to the second electrode layer 12 may be made higher than the content of the coloring material closer to the second layer 32. This can easily achieve both the function of capturing water as the sealing layer and the function of reducing color contrast on the light-receiving surface as the colored layer of the first layer 31.

Note that it is needless to mention that the present invention is not limited to the above embodiment, and various modifications and improvements are possible within the scope of the matter described in the claims of the present application.

Reference Signs List

1, 1X, 1Y, 1Z solar cell module
2 base material
3 solar battery cell
4 unit cell
10 photoelectric conversion layer
11 first electrode layer
12 second electrode layer
13 light absorption layer
14 electron transport layer
15 hole transport layer
16, 17, 18 groove
20, 20A, 20B extraction electrode layer
30 sealing layer
31 first layer
32 second layer
40 colored layer
41 intermediate layer
50 inorganic layer

**Claims**

1.  A solar cell module comprising:

    a base material;
    a solar battery cell disposed over the base material; and
    a sealing layer that covers the solar battery cell, wherein
    the solar battery cell includes a photoelectric conversion layer, a first electrode layer disposed on a first surface side of the photoelectric conversion layer, and a second electrode layer disposed on a second surface side of the photoelectric conversion layer,
    a perimeter of the photoelectric conversion layer is positioned inside a perimeter of the base material in plan view, and
    a colored layer is disposed at least in an area not overlapping with the photoelectric conversion layer.

2.  The solar cell module according to claim 1, wherein the colored layer has an absorption rate at least at some wavelengths of visible light within wavelengths of 380 nm to 780 nm of greater than or equal to 30%.

3.  The solar cell module according to claim 1, wherein an absorption rate of the colored layer is larger than an absorption rate of the photoelectric conversion layer at least at some wavelengths of visible light within wavelengths of 380 nm to 780 nm.

4.  The solar cell module according to claim 1, wherein a perimeter of the first electrode layer overlaps with a perimeter of the base material in plan view.

5. The solar cell module according to claim 1, further comprising an extraction electrode layer provided in an area not overlapping with the photoelectric conversion layer, wherein
the colored layer covers the entire second electrode layer except an area in which the extraction electrode layer is disposed.

6. The solar cell module according to claim 1, wherein the colored layer has insulation.

7. The solar cell module according to claim 1, wherein a thickness of the colored layer is smaller than a thickness of the photoelectric conversion layer.

8. The solar cell module according to claim 1, wherein the colored layer is disposed between the second electrode layer and the sealing layer.

9. The solar cell module according to claim 8, wherein

an intermediate layer is disposed between the second electrode layer and the colored layer, and
a refractive index of the intermediate layer is smaller than a refractive index of the colored layer and is larger than a refractive index of the second electrode layer.

10. The solar cell module according to claim 9, wherein the intermediate layer contains silicon nitride.

11. The solar cell module according to claim 1, wherein the photoelectric conversion layer contains a perovskite compound.

12. A solar cell module comprising:

a base material;
a solar battery cell disposed over the base material; and
a sealing layer that covers the solar battery cell, wherein
the solar battery cell includes a photoelectric conversion layer, a first electrode layer disposed on a first surface side of the photoelectric conversion layer, and a second electrode layer disposed on a second surface side of the photoelectric conversion layer,
a perimeter of the photoelectric conversion layer is positioned inside a perimeter of the base material in plan view, and
the sealing layer has an absorption rate at least at some wavelengths of visible light within wavelengths of 380 nm to 780 nm of greater than or equal to 50%.

13. The solar cell module according to claim 12, wherein the photoelectric conversion layer contains a perovskite compound.

14. The solar cell module according to claim 1 or 12, wherein a perimeter of the second electrode layer overlaps with a perimeter of the base material in plan view.

15. A method for producing a solar cell module, the method comprising:

forming a photoelectric conversion layer over a base material such that a perimeter is positioned inside a perimeter of the base material in plan view;
forming a colored layer at least in an area not overlapping with the photoelectric conversion layer; and
forming a sealing layer.

FIG. 1

1

2

10

20(20B)

20(20A)

40

X
Y

# FIG. 2

EP 4 642 196 A1

# FIG. 3

FIG. 4

FIG. 5

EP 4 642 196 A1

## INTERNATIONAL SEARCH REPORT

| | International application No. |
|---|---|
| | **PCT/JP2023/044813** |

### A. CLASSIFICATION OF SUBJECT MATTER

*H10K 39/10*(2023.01)i; *H10K 30/40*(2023.01)i; *H10K 30/88*(2023.01)i; *H10K 39/18*(2023.01)i
FI: H10K39/10; H10K39/18; H10K30/88; H10K30/40

According to International Patent Classification (IPC) or to both national classification and IPC

### B. FIELDS SEARCHED

Minimum documentation searched (classification system followed by classification symbols)

H10K30/00-39/38; H01L31/046-31/0468

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2014-192196 A (ROHM CO., LTD.) 06 October 2014 (2014-10-06) paragraphs [0023], [0024], [0076]-[0113], fig. 12-22 | 1-8, 14-15 |
| A | | 9-10 |
| X | JP 2011-70891 A (NISSHA PRINTING CO., LTD.) 07 April 2011 (2011-04-07) paragraphs [0016]-[0043], fig. 1-9 | 1-8, 14-15 |
| A | | 9-10 |
| X | JP 2012-182317 A (SHARP KABUSHIKI KAISHA) 20 September 2012 (2012-09-20) paragraphs [0119]-[0178], fig. 6A-17C | 12 |
| X | JP 63-299171 A (KYOCERA CORPORATION) 06 December 1988 (1988-12-06) p. 2, lower left column, line 15 to p. 3, lower left column, line 20, fig. 1 | 12 |
| Y | JP 2016-100357 A (KABUSHIKI KAISHA TOSHIBA) 30 May 2016 (2016-05-30) paragraphs [0009]-[0040], fig. 1, 2 | 1-8, 11-15 |
| A | | 9-10 |

☑ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **23 January 2024** | **06 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2023/044813**

| C. | DOCUMENTS CONSIDERED TO BE RELEVANT | |
|---|---|---|
| Category* | Citation of document, with indication, where appropriate, of the relevant passages | Relevant to claim No. |
| Y | US 2011/0114178 A1 (DU PONT APOLLO LTD.) 19 May 2011 (2011-05-19) paragraphs [0017]-[0028], fig. 1-3 | 1-8, 11-15 |
| A | | 9-10 |

Form PCT/ISA/210 (second sheet) (July 2022)

**INTERNATIONAL SEARCH REPORT**
Information on patent family members

International application No.

**PCT/JP2023/044813**

| Patent document cited in search report | | | Publication date (day/month/year) | Patent family member(s) | | | Publication date (day/month/year) |
|---|---|---|---|---|---|---|---|
| JP | 2014-192196 | A | 06 October 2014 | US 2015/0380670 A1 paragraphs [0325]-[0326], [0351]-[0365], fig. 19A-21B, 57A-64 WO 2014/136359 A1 | | | |
| JP | 2011-70891 | A | 07 April 2011 | (Family: none) | | | |
| JP | 2012-182317 | A | 20 September 2012 | WO 2012/117775 A1 | | | |
| JP | 63-299171 | A | 06 December 1988 | (Family: none) | | | |
| JP | 2016-100357 | A | 30 May 2016 | (Family: none) | | | |
| US | 2011/0114178 | A1 | 19 May 2011 | CN 102064215 A | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4776748 B